# EUROPEAN PATENT SPECIFICATION

(11) **EP 0 409 561 B1**
(45) Date of publication and mention of the grant of the patent: **17.09.1997**
(21) Application number: 90307802.0
(22) Date of filing: 17.07.1990
(51) Int. Cl.: H01L 21/336

(54) **Methods of manufacturing MIS semiconductor devices**
Verfahren zur Herstellung von MIS-Halbleiterbauelementen
Méthodes de fabrication d'éléments semi-conducteurs du type MIS

(30) Priority: 18.07.1989 JP 185759/89
(43) Date of publication of application: 23.01.1991
(73) Proprietor: SONY CORPORATION, Tokyo 141 (JP)
(72) Inventor: Ito, Shinichi, c/o Patents Division, Shinagawa-ku, Tokyo 141 (JP); Hoshi, Naoya, c/o Patents Division, Shinagawa-ku, Tokyo 141 (JP); Okamoto, Yutaka, c/o Patents Division, Shinagawa-ku, Tokyo 141 (JP)
(74) Representative: Cotter, Ivan John

(56) References cited:
- US-A- 4 744 859
- US-A- 4 818 714
- Monthly Semiconductor World, February 1987, pages 94-100.

## Description

This invention relates to methods of manufacturing MIS semiconductor devices.

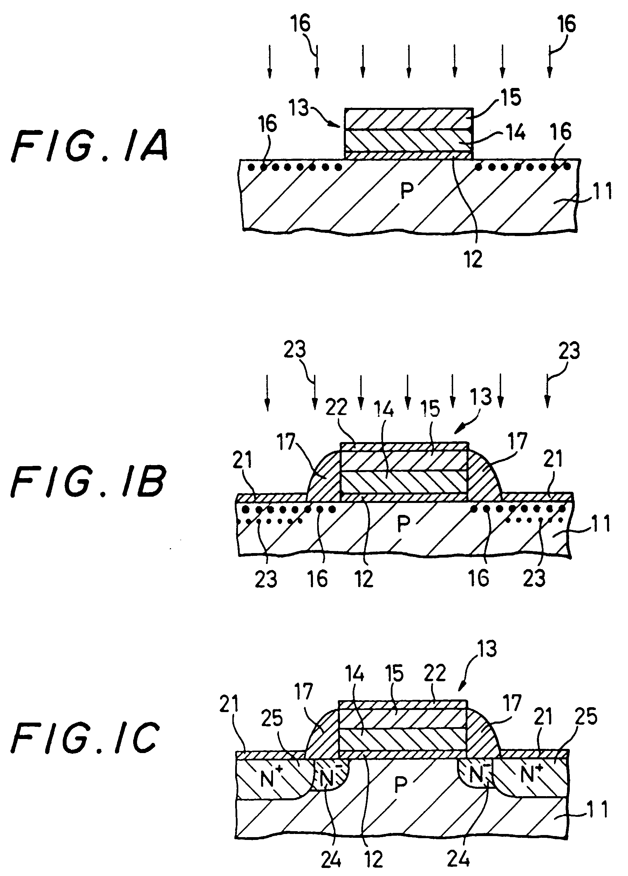

A method of manufacturing an MIS semiconductor device having an LDD structure is described in "Monthly Semiconductor World" (1987, February) pages 94 to 100. This method includes steps as shown in Figures 1A to 1C.

As shown in Figure 1A, an SiO₂ film 12 serving as a gate insulating film is formed on an Si substrate 11, and a gate electrode 13 is formed on the SiO₂ film 12. The gate electrode 13 has a polycide structure formed by a polycrystalline Si film 14 and a WSiₓ film 15. Thereafter, phosphorus ions 16 for forming an n⁻ type region for a source/drain region are implanted in the Si substrate 11 using the gate electrode 13 as a mask.

As shown in Figure 1B, an SiO₂ film 17 is deposited by atmospheric-pressure, low-temperature (about 410^{o}C) CVD using monosilane or the like. The SiO₂ film 17 is etched by RIE to form side walls of the gate electrode 13 using the SiO₂ film 17.

Thermal oxidation is performed for the resultant structure respectively to form SiO₂ films 21 and 22 on the surfaces of the Si substrate 11 and the WSiₓ film 15. The SiO₂ film 21 is used for preventing a decrease in gate breakdown voltage at the edge of the gate electrode 13.

Thereafter, arsenic ions 23 for forming an n⁺ type region for a source/drain region are implanted in the Si substrate 11 using the gate electrode 13 and the SiO₂ film 17 as masks.

As shown in Figure 1C, annealing is performed to the resultant structure to form n⁻ type regions 24 and n⁺ type regions 25 serving as source/drain regions.

The thermal oxidation for forming the SiO₂ films 21 and 22 is performed at a temperature within the range of 850°C to 900^{o}C. In an MIS transistor having a gate length of about 0.8 µm, however, when the high-temperature thermal oxidation is performed for a long time, the junction depth is undesirably increased. Therefore, since the thermal oxidation cannot be sufficiently performed, each of the SiO₂ films 21 and 22 has a thickness of about 10 nm.

When the SiO₂ film 21 has such a small thickness, the Si substrate 11 is substantially damaged during ion implantation of the arsenic 23. Therefore, crystal defects easily occur in the Si substrate 11. For this reason, degradation in device characteristics such as an increase in leakage current through a junction occurs, and the production yield is decreased.

In addition, since the RIE for forming the SiO₂ films 17 serving as the side walls of the gate electrode 13 causes damage to the surfaces of the Si substrate 11 and the WSiₓ film 15, the SiO₂ films 21 and 22 are difficult to grow. For this reason, the thickness of the SiO₂ film 21 is small, and the above problem of easy formation of crystal defects in the Si substrate 11 typically occurs.

According to the present invention there is provided a method of manufacturing an MIS semiconductor device, the method comprising the steps of:
forming a gate electrode on a gate insulating film on a silicon semiconductor substrate;
forming a first impurity region having a relatively low impurity concentration in said substrate using said gate electrode as a mask;
forming side walls on said gate electrode;
forming a first SiO₂ film to cover exposed surfaces of said substrate, said side walls and said gate electrode;
oxidizing at least the surface of said first SiO₂ film over said substrate to form a second SiO₂ film on the first SiO₂ film; and
forming a second impurity region having a relatively high impurity concentration in said substrate using said gate electrode and side walls covered with said first SiO₂ film as a mask.

In a method according to the present invention, after the first SiO₂ film (insulating film) has been formed on the side walls, the gate electrode and the surface of the semiconductor substrate, the surface is oxidized. Therefore, upon formation of the second impurity region having a relatively high impurity concentration in the semiconductor substrate, the semiconductor substrate is only slightly damaged even if the oxide layer is thin, and crystal defects tend not be formed in the semiconductor substrate.

Since the oxide layer is formed in addition to the first SiO₂ film (insulating film), a decrease in gate breakdown voltage at the edge portion of a gate electrode can be prevented.

The invention will now be described by way of example with reference to the accompanying drawings, throughout which like parts are referred to by like references, and in which:
Figures 1A to 1C are sectional side views showing the steps in manufacturing an MIS semiconductor device by a previously proposed method;
Figures 2A to 2D are sectional side views showing the steps in manufacturing an MIS semiconductor device according to a first embodiment of the present invention; and
Figure 3 is a graph showing step coverage in an MIS semiconductor device.

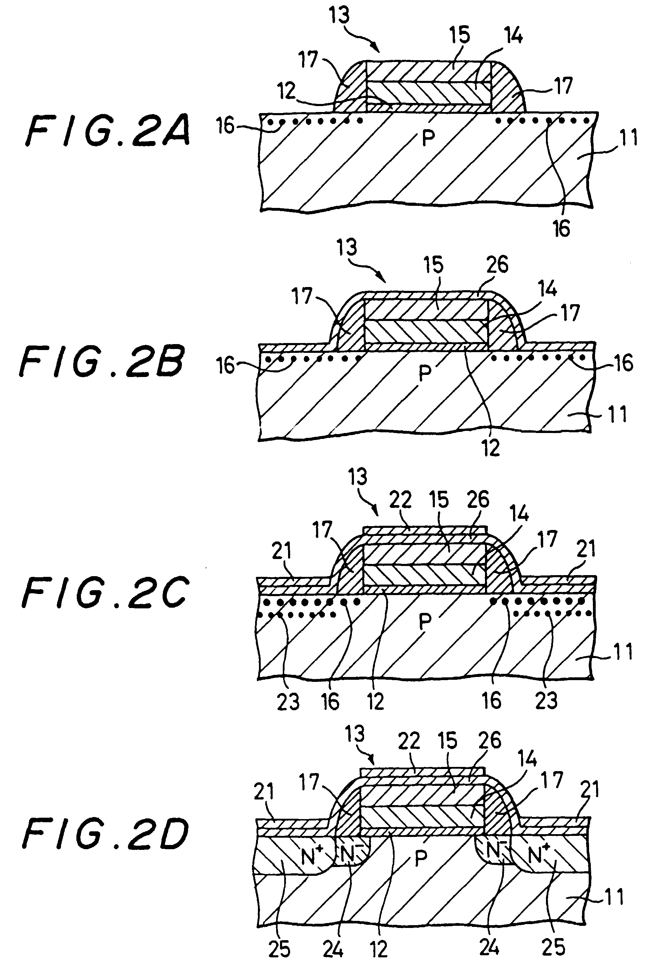

In the first embodiment, as shown in Figure 2A, an SiO₂ film 12, a polycrystalline Si film 14 and a WSiₓ film 15 are formed on an Si substrate 11, and phosphorus ions 16 are implanted in the Si substrate 11. The same procedures as in Figures 1A to 1C are performed until an SiO₂ film 17 is formed on the Si substrate 11.

In the first embodiment, as shown in Figure 2B, an SiO₂ film 26 having a thickness of 10 to 30 nm is deposited on the surfaces of the Si substrate 11 and the WSiₓ film 15 by low-pressure, high-temperature (about 700°C) CVD using TEOS (tetraethylorthosilicate) or the like. With this CVD, the deposition rate can be decreased. Therefore, the SiO₂ film 26 having a small thickness can be deposited with good controllability.

The same procedures as in Figures 1A to 1C are performed. That is, as shown in Figure 2C, SiO₂ films 21 and 22 are formed, and arsenic ions 23 are implanted. As shown in Figure 2D, an n⁻ type region 24 and an n⁺ type region 25 are formed by annealing.

In this first embodiment, since the SiO₂ film 26 is formed in addition to the SiO₂ film 21, even if the SiO₂ film 21 has a small thickness of about 10 nm as shown in Figures 1A to 1D, the Si substrate 11 is only slightly damaged during implantation of the arsenic ions 23. Therefore, crystal defects tend not to occur in the Si substrate 11. Thus an MIS semiconductor device having excellent characteristics can be manufactured at a high yield.

The WSiₓ film 15 in an amorphous state is crystallized by heat generated during formation of the SiO₂ films 21 and 22, and the protection capability of the WSiₓ film 15 against ion implantation is degraded. Therefore, when only the SiO₂ film 22 having the thickness of about 10 nm is formed on the surface of the WSiₓ film 15 like in Figure 1B or 1C, the arsenic ions 23 easily reach a channel portion through the gate electrode 13 during implantation of the arsenic ions 23.

However, in the first embodiment, in addition to the SiO₂ film 22, the SiO₂ film 26 is formed on the WSiₓ film 45. Therefore, the arsenic ions 23 cannot reach the channel portion through the gate electrode 13. Since the temperature of the low-pressure, high-temperature CVD for forming the SiO₂ film 26 is lower than that of thermal oxidation, junction depth is not increased even when the SiO₂ film 26 is formed.

The second embodiment has substantially the same steps as in the first embodiment, except that SiO₂ films 17 serving as the side walls of a gate electrode 13 are formed by low-pressure, high-temperature CVD using TEOS or the like, and an SiO₂ film 26 is formed by atmospheric-pressure, low-temperature CVD.

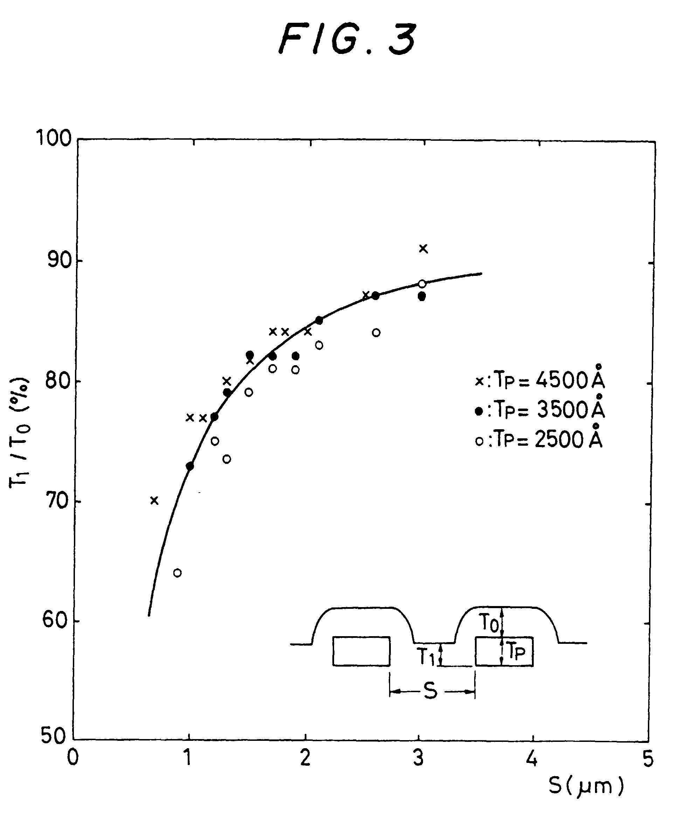

When the SiO₂ films 17 are formed by atmospheric-pressure, low-temperature CVD like the first embodiment, step coverage of the SiO₂ film 17 is good at a low-density pattern region such as a peripheral circuit portion, but is poor at a high-density pattern region such as a memory cell. Figure 3 shows the step coverage of the SiO₂ film 17.

Therefore, when RIE is performed for the SiO₂ film 17, portions of the SiO₂ film 17 except for the side walls of the gate electrode 13 on the surface of the Si substrate 11 is removed from the memory cell due to poor step coverage. At this time, the SiO₂ film 17 is left on the peripheral circuit portion. If the RIE is stopped at this time, and then the arsenic ions 23 are implanted, the arsenic ions 23 do not reach deeply into the Si substrate 11 at the peripheral circuit portion. Therefore, an impurity diffusion layer has a high sheet resistance.

In order to avoid this, the RIE must be performed until the SiO₂ film 17 is removed from the surface of the Si substrate 11 except for the side walls of the gate electrode 13, even in the peripheral circuit portion. However, in this case, the memory cell is excessively over-etched. When such over-etching occurs, the Si substrate 11 is frequently damaged. Therefore, crystal defects easily occur in the Si substrate 11 resulting in an inferior memory cell.

In contrast to this, with the second embodiment, since the SiO₂ film 17 is formed by low-pressure, high-temperature CVD using TEOS or the like, the SiO₂ film 17 has good step coverage even in a high-density pattern region.

With the second embodiment, an MIS semiconductor device having more excellent characteristics than those of the first embodiment can be manufactured at a higher yield than the first embodiment.

Note that, when both the SiO₂ films 17 and 26 are formed by low-pressure, high temperature CVD, the WSiₓ film 15 is heated twice to a high temperature of 600^{o}C or more while the WSiₓ film 15 is exposed, thereby easily peeling the WSiₓ film 15 from a polycrystalline Si film 14. However, since the SiO₂ film 26 is formed by atmospheric-pressure, low-temperature CVD, the WSiₓ film 15 is not peeled from the polycrystalline Si film 14.

In the third embodiment a semiconductor device is manufactured following substantially the same procedures as in the second embodiment except that, when an SiO₂ film 17 is not left on the surface of an Si substrate 11 in a high-density pattern region such as a memory cell except for the side walls of a gate electrode 13, RIE applied to the SiO₂ film 17 is stopped and the SiO₂ film 17 remaining in a low-density pattern region such as a peripheral circuit portion at this time is removed by post wet etching. A stop time of the RIE applied to the memory cell or the like can be detected using an end point detector for etching.

When wet etching is performed as in the third embodiment, the Si substrate 11 is not damaged. In addition, since the etching amount is about several tens of nm, the shapes of the SiO₂ films 17 of the side walls of the gate electrode 13 are almost not affected.

Therefore, with the third embodiment, an MIS semiconductor device having more excellent characteristics than those of the second embodiment can be manufactured at a yield higher that the second embodiment.

When the SiO₂ film 17 is formed by atmospheric-pressure, low-temperature CVD instead of low-pressure, high-temperature CVD using TEOS or the like as in the third embodiment, cavities are undesirably formed in the shoulder portions of the SiO₂ film 17.

In the fourth embodiment, a memory device having a memory cell in which each interval between gate electrodes 13 falls within the range of 1.4 to 3.6 µm and a peripheral circuit portion in which each interval between gate electrodes 13 is more than 3.6 µm is manufactured.

In the fourth embodiment, an SiO₂ film 17 is deposited by atmospheric-pressure, low-temperature CVD using monosilane or the like, and RIE applied to the SiO₂ film 17 is absent in a 3.6µm interval between the gate electrodes 13 on the surface of an Si substrate 11, except for the side walls of the gate electrode 13.

Thereafter, the memory cell is masked by a resist film. In order to remove a portion of the SiO₂ film 17 from the surface of the Si substrate 11, which corresponds to a peripheral circuit portion and excludes portions left on side walls of the gate electrode 13, the RIE is started again.

## Claims

1. A method of manufacturing an MIS semiconductor device,the method comprising the steps of:
forming a gate electrode (13) on a gate insulating film (12) on a silicon semiconductor substrate (11);
forming a first impurity region (24) having a relatively low impurity concentration in said substrate (11) using said gate electrode (13) as a mask;
forming side walls (17) on said gate electrode (13);
forming a first SiO₂ film (26) to cover exposed surfaces of said substrate (11), said side walls (17) and said gate electrode (13);
oxidizing at least the surface of said first SiO₂ film (26) over said substrate (11); to form a second SiO₂ film (21) on the first SiO₂ film (26); and
forming a second impurity region (25) having a relatively high impurity concentration in said substrate (11) using said gate electrode (13) and side walls (17) covered with said first SiO₂ film (26) as a mask.

2. A method according to claim 1, wherein the thickness of said first SiO₂ film (26) falls within a range of 10 to 30 nm and the thickness of said second SiO₂ film (21) is about 10 nm.

3. A method according to claim 2, wherein said side walls (17) are formed from an SiO₂ film (17) deposited by atmospheric-pressure, low-temperature CVD using monosilane to cover the surfaces of said substrate (11) and said gate electrode (13), and the first SiO₂ film (26) is deposited by low-pressure, high-temperature CVD using tetraethylorthosilicate.

4. A method according to claim 3, wherein to form said side walls (17) said deposited SiO₂ film (17) is partially removed by reactive ion etching to expose at least a portion of said substrate (11);
a coating layer is formed on a region where said substrate (11) is exposed; and
said deposited SiO₂ film (17) is further removed by reactive ion etching using said coating layer as a mask to form said side walls (17).

5. A method according to claim 2, wherein said side walls are formed from an SiO₂ film (17) deposited by low-pressure, high-temperature CVD using tetraethylorthosilicate to cover the surfaces of said gate electrode (13) and said substrate (11), and the first SiO₂ film (26) is deposited by atmospheric-pressure, low-temperature CVD using monosilane.

6. A method according to claim 5, wherein to form said side walls (17) said deposited SiO₂ film (17) is partially removed by reactive ion etching to expose at least a portion of said substrate (11) and said deposited SiO₂ film (17) is further removed by wet etching to form said side walls (17).

## Patentansprüche

1. Verfahren zur Herstellung eines MIS-Halbleiterbauelements, wobei das Verfahren folgende Schritt aufweist:
Bilden einer Gate-Elektrode (13) auf einem Gate-Isolationsfilm (12) auf einem Silizium-Halbleitersubstrat (11);
Bilden eines ersten Verunreinigungsbereichs (24), der eine relativ niedrige Verunreinigungskonzentration hat, in diesem Substrat (11), wobei die Gate-Elektrode (13) als eine Maske verwendet wird;
Bilden von Seitenwänden (17) auf der Gate-Elektrode (13);
Bilden eines ersten SiO₂-Films (26), um unverdeckte Flächen des Substrats (11), der Seitenwände (17) und der Gate-Elektrode (13) zu überdecken;
Oxidieren zumindest der Fläche des ersten SiO₂-Films (26) über dem Substrat (11), um einen zweiten SiO₂-Film (21) auf dem ersten SiO₂-Film (26) zu bilden; und
Bilden eines zweiten Verunreinigungsbereichs (25), der eine relativ hohe Verunreinigungskonzentration hat, im Substrat (11), wobei die Gate-Elektrode (13) und die Seitenwände (17), die mit dem ersten SiO₂-Film (26) überdeckt sind, als eine Maske verwendet wird.

2. Verfahren nach Anspruch 1, wobei die Dicke des ersten SiO₂-Films (26) in einen Bereich von 10 bis 30 nm fällt und die Dicke des zweiten SiO₂-Films (21) ungefähr 10 nm beträgt.

3. Verfahren nach Anspruch 2, wobei die Seitenwände (17) aus einem SiO₂-Film (17) gebildet werden, der durch ein Luftdruck-Niedertemperatur-CVD-Verfahren abgeschieden wird, wobei Monosilan verwendet wird, um die Flächen des Substrats (11) und der Gate-Elektrode (13) zu überdecken, und wobei der erste SiO₂-Film (26) durch ein Niederdruck-Hochtemperatur-CVD-Verfahren abgeschieden wird, wobei Tetraethylorthosilikat verwendet wird.

4. Verfahren nach Anspruch 3, wobei - um die Seitenwände (17) zu bilden - der abgeschiedene SiO₂-Film (17) teilweise durch reaktives Ionen-Ätzen entfernt wird, um zumindest einen Bereich des Substrats (11) freizulegen;
eine Überzugsschicht auf einem Bereich gebildet wird, wo das Substrat (11) freigelegt ist; und
der aufgebrachte SiO₂-Film (17) weiter durch reaktives Ionen-Ätzen entfernt wird, wobei die Überzugsschicht als eine Maske verwendet wird, um die Seitenwände (17) zu bilden.

5. Verfahren nach Anspruch 2, wobei die Seitenwände aus einem SiO₂-Film (17) gebildet werden, der durch ein Niederdruck-Hochtemperatur-CVD-Verfahren abgeschieden wird, wobei Tetraethylorthosilikat verwendet wird, um die Flächen der Gate-Elektrode (13) und des Substrats (11) zu überdecken, und wobei der erst SiO₂-Film (26) durch ein Luftdruck-Niedertemperatur-CVD-Verfahren abgeschieden wird, wobei Monosilan verwendet wird.

6. Verfahren nach Anspruch 5, wobei - um die Seitenwände (17) zu bilden - der abgeschiedene SiO₂-Film (17) teilweise durch reaktives Ionen-Ätzen entfernt wird, um zumindest einen Bereich des Substrats (11) freizulegen, und der aufgebrachte SiO₂-Film (17) weiter durch Naß-Ätzen entfernt wird, um die Seitenwände (17) zu bilden.

## Revendications

1. Procédé de fabrication d'un dispositif à semi-conducteur MIS, le procédé comprenant les étapes :
de formation d'une électrode de grille (13) sur un film (12) d'isolation de grille sur un substrat (11) semi-conducteur de silicium ;
de formation dans ledit substrat (11), en utilisant comme masque ladite électrode de grille (13), d'une première zone d'impureté (24) ayant une concentration d'impureté relativement basse ;
de formation de parois latérales (17) sur ladite électrode de grille (13);
de formation d'un premier film (26) de SiO₂ pour recouvrir les surfaces dénudées dudit substrat (11), lesdites parois latérales (17) et ladite électrode de grille (13) ;
d'oxydation d'au moins la surface dudit premier film (26) de SiO₂ sur ledit substrat (11) pour former un second film (21) de SiO₂ sur le premier film (26) de SiO₂ ; et
de formation dans ledit substrat (11), en utilisant comme masques ladite électrode de grille (13) et lesdites parois latérales (17) recouvertes par ledit premier film (26) de SiO₂, d'une seconde zone d'impureté (25) ayant une concentration d'impureté relativement forte.

2. Procédé selon la revendication 1, dans lequel l'épaisseur dudit premier film (26) de SiO₂ tombe à l'intérieur d'une fourchette de 10 à 30 nm et l'épaisseur dudit second film (21) de SiO₂ est d'environ 10 nm.

3. Procédé selon la revendication 2, dans lequel lesdites parois latérales (17) sont faites à partir d'un film (17) de SiO₂ déposé par CVD (dépôt chimique en phase vapeur) à la pression atmosphérique, à basse température, utilisant du monosilane, pour recouvrir les surfaces dudit substrat (11) et de ladite électrode de grille (13), et dans lequel le premier film (26) de SiO₂ est déposé par CVD à basse pression, haute température, en utilisant un tétraéthylorthosilicate.

4. Procédé selon la revendication 3, dans lequel, pour former lesdites parois latérales (17), ledit film (17) de SiO₂ est partiellement éliminé par attaque par ions réactifs pour dénuder au moins une partie dudit substrat (11) ;
dans lequel une couche de revêtement est formée sur une zone où ledit substrat (11) est dénudé ; et
dans lequel ledit film (17) de SiO₂ déposé est éliminé davantage par attaque par ions réactifs en utilisant ladite couche de revêtement comme masque pour former lesdites parois latérales (17).

5. Procédé selon la revendication 2, dans lequel lesdites parois latérales sont faites à partir d'un film (17) de SiO₂ déposé par CVD à basse pression haute température en utilisant du tétraéthylorthosilicate, pour recouvrir les surfaces de ladite électrode de grille (13) et dudit substrat (11), et dans lequel le premier film (26) de SiO₂ est déposé par CVD à la pression atmosphérique, à basse température, en utilisant du monosilane.

6. Procédé selon la revendication 5, dans lequel, pour former lesdites parois latérales (17), ledit film (17) de SiO₂ est partiellement éliminé par attaque par ions réactifs pour dénuder au moins une partie dudit substrat (11); et dans lequel ledit film (17) de SiO₂ déposé est éliminé davantage par attaque humide pour former lesdites parois latérales (17).
